# EUROPEAN PATENT SPECIFICATION

(11) **EP 3 572 908 B1**
(45) Date of publication and mention of the grant of the patent: **08.07.2020**
(21) Application number: 18197287.8
(22) Date of filing: 27.09.2018
(51) Int. Cl.: G06F 1/20, H05K 7/20

(54) **DUCTING ARRANGEMENT FOR DOWNSTREAM COMPONENTS**
LEITUNGSANORDNUNG FÜR DOWNSTREAM-KOMPONENTEN
AGENCEMENT DE TUYAUTERIE POUR COMPOSANTS EN AVAL

(30) Priority: 25.05.2018 US 201815989435
(43) Date of publication of application: 27.11.2019
(73) Proprietor: Quanta Computer Inc., Taoyuan City 333 (TW)
(72) Inventor: CHEN, Chao-Jung, Taoyuan City 333 (TW); HUANG, Yu-Nien, Taoyuan City 333 (TW); HSU, Jung-Hui, Taoyuan City 333 (TW)
(74) Representative: Winter, Brandl, Fürniss, Hübner, Röss, Kaiser, Polte - Partnerschaft mbB

(56) References cited:
- US-A1- 2012 212 906
- US-A1- 2015 277 518
- US-A1- 2016 088 774
- US-A1- 2017 363 316

## Description

### TECHNICAL FIELD

The present disclosure is directed to systems and methods for improved cooling more particularly to systems and methods for improved cooling of downstream components using ducting.

### BACKGROUND

Electronic devices contained with the housing of a server generate heat which requires the server to be cooled in order to maintain the electronic devices in the server to operating temperature specifications. Typically, such servers are cooled via fans or other devices that force air through the server. US 2015/277518 A1 provides a system including a housing and a baffle disposed in the housing used to duct cooling air through different corridors. US 2016/0088774 A1 discloses an information handling system chassis having an internal ducting structure for cooling. Moreover, US 2012/0212906 A1 shows an electronic device with a motherboard and an air duct containing a cover portion and a guiding panel. Furthermore, US 2017/0363316 A1 discloses an air duct for a computing device including a duct housing with a first and a second end and at least one vent inbetween.

In some conventional servers, a ducting design is used to control the flow of air required for cooling of different components. In one typical server design, CPUs and memory components may be placed in a server in a shadow arrangement and separated ducting arrangements. That is, the CPUs are arranged in series such that one is upstream and another is downstream, with respect to airflow through the server. Similarly, memory components are also arranged in series such that one is upstream and another is downstream, with respect to airflow through the server. Additionally, a ducting arrangement can be provided so as to direct a portion of incoming cooling air through only the memory components and a second portion of the incoming cooling air through only the CPUs.

This type of design creates two problems due to the incoming air being pre-heated by upstream components. First, the efficiency of the cooling air is reduced. That is, warmer air is less capable of cooling a downstream component. Second, excess electrical usage results. That is, since the cooling efficiency is reduced, a cooling fan must typically be sped up to increase airflow to overcome the cooling inefficiency.

Accordingly, there is a need to provide a cooling system in server systems and other computing devices which improves downstream cooling without requiring significantly larger energy use.

### SUMMARY

A ducting system for computing devices containing multiple arrangements of components in a shadow arrangement with respect to incoming air is provided. The ducting system includes multiple ducts for directing air to rear side components in the shadow arrangement with little or no heating of the air by front side components in the shadow arrangement.

In one configuration, according to the invention, there is provided a computing device wherein the ducting system comprises first heat generating components in a shadow arrangement with respect to incoming air and second heat generating components in a shadow arrangement with respect to the incoming air. The first heat generating components are positioned in the computing device adjacent to the second heat generating components. In this configuration, the ducting arrangement includes first ducts for directing a portion of the incoming air through a rear one of the first heat generating components and a front one of the second heat generating components. The ducting arrangement also includes second ducts for directing a portion of the incoming air through a rear one of the second heat generating components, but bypassing the first heat generating components and the front one of the second heat generating components.

In some implementations, the ducts can be configured to have shared walls.

The first ducts can consist of a plurality of ducts, with a first portion configured to bypass the front one of the first heat generating components. A second portion of each of the ducts can have walls separating the front one of the second heat generating components from a front one of the first heat generating components. Further, these ducts can include outlets for directing air in the second portion of each of the ducts towards the rear one of the second heat generating components. In some implementations, the second ducts can be positioned between the first and second aforementioned portions of the first ducts.

The ducts can be formed from materials having a thermal conductivity of at most 0.55 W/(m K) at 25°C, such as polymers and ceramics.

In the computing device, each of the first heat generating components can be a processing unit and each of the second heat generating components can be a memory device.

In some implementations, a unitary shell can be provided and positioned in the computing device, where the unitary shell defines the ducts.

In an implementation, the computing device can include first, second and third ducts. The first duct can be configured for directing a portion of the incoming air through a rear one of the first heat generating components and a front one of the second heat generating components. The second duct can be configured for directing a portion of the incoming air through a rear one of the second heat generating components and bypassing the first heat generating components and the front one of the second heat generating components. The third duct can be configured for directing a portion of the incoming air through a rear one of the first heat generating components and bypassing the front one of first heat generating components and the second heat generating components. Hereby, an amount of the incoming air heated by the front one of the second heat generating components is less than an amount of the incoming air heated by the front one of the first heat generating components.

In this implementation, the first duct and the second duct share at least one common wall and the second duct and the third duct share at least one common wall.

In addition, the first duct can include walls separating the front one of the second heat generating components from a front one of the first heat generating components. Also, the first duct can include an outlet for directing air in the first duct towards the rear one of the second heat generating components.

These and other objects will be better understood when read in conjunction with the detailed description and the appended drawings.

### BRIEF DESCRIPTION OF THE DRAWINGS

FIG. 1 is a schematic side cross-sectional view of a server containing a ducting arrangement according to the prior art.
FIG. 2 is a schematic side view cross-sectional view of a server containing a ducting arrangement according to the present disclosure.
FIG. 3 is a schematic perspective view, partially cross-sectioned view of a server containing a ducting arrangement according to the present disclosure

### DETAILED DESCRIPTION

The present invention is described with reference to the attached figures, wherein like reference numerals are used throughout the figures to designate similar or equivalent elements. The figures are not drawn to scale and are provided merely to illustrate the instant invention. Several aspects of the invention are described below with reference to example applications for illustration. It should be understood that numerous specific details, relationships, and methods are set forth to provide a full understanding of the invention. One having ordinary skill in the relevant art, however, will readily recognize that the invention can be practiced without one or more of the specific details or with other methods. In other instances, well-known structures or operations are not shown in detail to avoid obscuring the invention. The present invention is not limited by the illustrated ordering of acts or events, as some acts may occur in different orders and/or concurrently with other acts or events. Furthermore, not all illustrated acts or events are required to implement a methodology in accordance with the present invention.

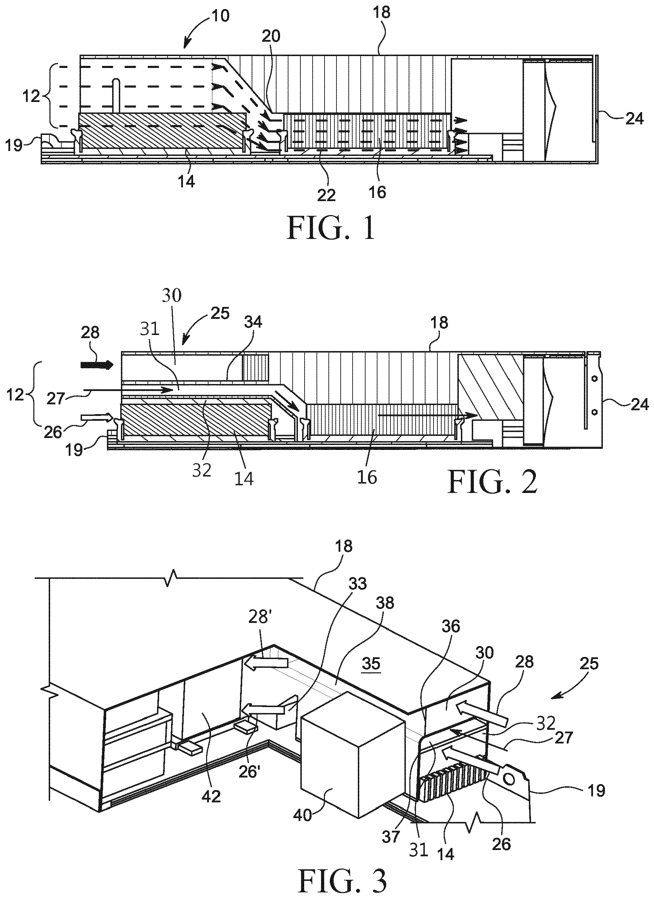

As shown in FIG. 1 (Prior Art), a ducting arrangement can include a conventional duct 10 that takes in incoming air 12 and directs the air at front memory 14 at a front side 19 of server 18 and a rear memory 16 at the rear side 22 of server 18. In particular, the duct 10 directs the incoming air 12 through memory 14 first. The duct 10 collect airs passing through memory 14 and other portions of duct 10 to provide cooling air 20 for rear memory 16. The duct 10 also diverts the incoming air 12 away from any CPUs in server 18 in order to avoid any heating of incoming air 12 by such CPUs. An adjacent duct (not shown) can be used to direct a portion of incoming air through CPUs adjacent to memory 14 and memory 16.

When used with lower power memory components, the duct 10 allows the incoming air 12 to remain cool enough to provide efficient cooling of memory 14 and memory 16. However, newer memory technologies have far higher power requirements as a consequence of the higher speed of such newer memory technologies. As a result, each of memory 14 and memory 16 can dissipate significantly higher amounts of heat. The memory power would be up to 18W. It caused the memory temperature to reach over 85°C (memory spec). Therefore, the incoming air 12 entering the duct 10 can be significantly pre-heated while traversing though memory 14 and prior to reaching memory 16. The pre-heating of incoming air within the duct 10 causes any cooling air 20 reaching memory 16 to be of a higher temperature than incoming cooling air 12 entering duct 10. This pre-heating of incoming air 12 therefore reduces the cooling efficiency of the cooling air 20 reaching memory 16. In turn, this reduced cooling efficiency can therefore cause the temperature of the memory 16 to exceed operating specifications and may further cause malfunction or even premature failure of the memory 16.

In view of the limitations of conventional ducting arrangements for cooling of newer memory technologies, the present disclosure contemplates a new duct design. This is illustrated in FIGs. 2 and 3. FIG. 2 is a schematic side view cross-sectional view of a server containing a ducting arrangement according to the present disclosure. FIG. 3 is a schematic perspective view, partially cross-sectioned view of a server containing a ducting arrangement according to the present disclosure.

Although the specification is directed to an implementation in a particular type of computing device, namely a server, this is only for ease of explanation. Therefore, the present disclosure is applicable to any computing device containing heat generating electronic devices arranged in a shadow arrangement with respect to airflow. Thus, the present disclosure contemplates that such computing devices can include any type of components, such as CPU, GPU, memory, and similar electronic devices.

As shown in FIGs. 2 and 3, the ducting arrangement 25 of server 18 includes ducts 32, 31, and 30. These ducts 32, 31, and 30 are configured to separate the incoming air 12 into three portions, as indicated by arrows 26, 27, and 28, respectively. These ducts are arranged so as to provide cooling of different portions of the server 18.

Referring first to duct 30, this duct is configured to primarily provide cooling of a rear CPU in server 18. In particular, the portion of incoming air 12 shown by arrow 28 is initially directed through duct 30 and is subsequently directed towards rear CPU 42, as shown by arrow 28' in FIG. 3. The interior surfaces of duct 30 can be shaped so as to not only provide the necessary directing of the airflow, but also encourage smooth flow of the portion of the incoming air 12 flowing through duct 30. That is, this portion of the incoming air initially follows a path that does not go through front CPU 40 (the position of which is shown by dotted lines in FIG. 3). As a result, this portion of the incoming air 12 encounters little or no preheating due to front CPU 40. Accordingly, the portion of incoming air 12 that is subsequently directed towards rear CPU 42, as shown by arrow 28', provides cooler air for cooling rear CPU 42.

Referring next to duct32, this duct is configured primarily to provide cooling of front memory 14. Additionally, this duct is also configured to provide some cooling of rear CPU 42. As shown in FIGs. 2 and 3, a portion of incoming air 12, shown by arrow 26, is initially directed through duct32. Duct 32 is configured to direct this portion of the incoming air 12 through front memory 14 for purposes of cooling front memory 14. Thereafter, this portion of the incoming air 12 is also directed towards rear CPU 42 via outlet 33, as shown by arrow 26' in FIG. 3. The interior surfaces of duct 32 can be shaped so as to encourage smooth flow of the portion of the incoming air 12 flowing through duct 32.

Although air exiting through outlet 33 may be heated by memory 14, the amount of air heating provided by memory 14 is typically less that an amount of air heating that would be provided by a front CPU 40. Thus, the air exiting through outlet 33 can still have sufficient capacity to cool hotter components, such as rear CPU 42. Consequent, the portion of the incoming air 12 exiting outlet 33, as indicated by arrow 26', serves to cool the rear CPU 42.

As illustrated in FIG. 3, at least a portion of duct 30 is shown as having an open portion 38 facing front CPU 40 while duct 32 includes no such open portion (except for outlet 33), i.e., includes a wall 37, as shown in FIG. 3. In duct 32, the wall 37 is designed to keep the portion of incoming air 12 being directed through memory 14 from being heated by CPU 40. However, the present disclosure contemplates that in some configurations, the duct 32 can also have open portions or even be completely open like duct 30 in FIG. 3. Similarly, duct 30 can alternatively be designed like duct 32. That is, to keep the portion of the incoming air traveling through duct 30 cooler, a wall 36 (shown in dotted line) can also be provided to separate the interior of duct 30 from CPU 40.

In addition to ducts 30 and 32, the ducting arrangement 25 can also include duct 31 situated between ducts 30 and 32, as shown in FIGs. 2 and 3. This duct is configured to provide cooling of rear memory 16. As illustrated in FIGs. 2 and 3, duct 31 is configured so that a portion of incoming air 12, shown by arrow 27, is directed to rear memory 16 without any pre-heating by memory 14 or any of CPUs 40 or 42. Thus, the portion of the incoming air 12 reaching memory 16 is maintained cooled so as to provide efficient cooling of memory 16. As with ducts 30 and 32, the interior surfaces of duct 31 can be configured so as to direct air smoothly.

While FIGs. 2 and 3 illustrate a particular arrangement and sizing of ducts 30, 31, and 32, the present disclosure contemplates that other arrangements of these ducts can be used without limitation. Thus, the arrangement and sizing of ducts can vary based on size of the various components being cooled, their arrangement in server 18, the available space within server 18, and cooling requirements for the various components. For example, although the ducts 30, 31, and 32 are shown in FIGs. 2 and 3 as including common walls, in other implementations, such ducts can include separate walls. In another example, although the ducts 30, 31, and 32 are shown in FIGs. 2 and 3 as providing substantially parallel and adjacent air paths, in other implementations such ducts need not be adjacent nor parallel to each other.

In some implementations, the ducts 30, 31, and 32 may be defined by a unitary shell 35 disposed on a motherboard 24 of server 18 that supports memories 14 and 16 and CPU42. However, the present disclosure contemplates that the ducts 30, 31, and 32 can be defined using any number of elements.

The materials of construction of the ducts described herein can be of a low thermal conductivity material so as to minimize any heat transfer between the common walls, such as wall 34 separating ducts 30 and 31, and common wall 37 separating ducts 31 and 32. Suitable materials for the ducts include polymers and ceramics. However, in other implementations, any material can be used that has a thermal conductivity of 0.55 W/ (m K) or less at 25°C.

It should be noted that the presentation of one or more of the components shown in the various figures may have been simplified for ease of discussion. Therefore, it should be understood that certain components illustrated may include additional portions or elements that are not separately illustrated or identified. For example, the regions identified as CPUs 40 and 42 can include the actual processing unit, but may also include or incorporate other features, such as heat sink structures. Therefore, the present disclosure contemplates that one skilled in the art will recognize that computing devices implementing the ducting arrangements described herein can include more or less elements than illustrated or identified in the various figures.

## Claims

1. A ducting arrangement (25) in a computing device wherein the ducting arrangement (25) comprises a plurality of first heat generating components (40, 42) and a plurality of second heat generating components (14, 16) wherein the first heat generating components (40, 42) and the second heat generating components (14, 16) are in a shadow arrangement with respect to the incoming air (12),
wherein the first heat generating components (40, 42) are positioned in the computing device adjacent to the second heat generating components (14, 16), **characterized in that** the ducting arrangement (25) comprises:
one or more first ducts (32) wherein each of the first ducts (32) is used for directing a portion of the incoming air (12) through a rear one (42) of the first heat generating components (40, 42) and a front one (14) of the second heat generating components (14, 16); and
one or more second ducts (31) wherein each of the second ducts (31) is used for directing another portion of the incoming air (12) through a rear one (16) of the second heat generating components (14, 16) and bypassing the first heat generating components (40, 42) and the front one (14) of the second heat generating components (14, 16).

2. The ducting arrangement of claim 1, wherein the one or more first ducts (32) and the one or more second ducts (31) share at least one common wall (34, 37).

3. The ducting arrangement of claim 1, wherein the one or more first ducts 32) comprise a plurality of ducts, and wherein a first portion of each of the ducts bypasses the front one (40) of the first heat generating components (40, 42).

4. The ducting arrangement of claim 3, wherein a second portion of each of the ducts comprises one or more walls (37) separating the front one (14) of the second heat generating components (14, 16) from a front one (40) of the first heat generating components (40, 42), and wherein the second portion of each of the ducts comprises at least one outlet (33) for directing air in the second portion of each of the ducts towards the rear one (42) of the first heat generating components (40, 42).

5. The ducting arrangement of claim 4, wherein the one or more second ducts (31) are positioned between the first portion of each of the ducts and the second portion of each of the ducts.

6. The ducting arrangement of claim 1, wherein the one or more first ducts (32) and the one or more second ducts (31) are formed from a material having a thermal conductivity of at most 0.55 W/(m K) at 25°C.

7. The ducting arrangement of claim 6, wherein the material having the thermal conductivity of at most 0.55 W/(m K) at 25°C is a material selected from the group consisting of polymers and ceramics.

8. The ducting arrangement of claim 1, further comprising a unitary shell (35) defining the one or more first ducts (32) and the one or more second ducts (31).

9. The ducting arrangement (25) of claim 1 wherein the ducting arrangement (25) further comprises:
a third duct (30) wherein the third duct (30) is used for directing yet another portion of the incoming air (12) through the rear one (42) of the first heat generating components (40, 42) and bypassing a front one (40) of the first heat generating components (40, 42) and the second heat generating components (14, 16);
wherein an amount of the incoming air (12) heated by the front one (14) of the second heat generating components (14, 16) is less than an amount of the incoming air (12) heated by the front one (40) of the first heat generating components (40, 42).

10. The ducting arrangement of claim 9, wherein the first duct (32) and the second duct (31) share at least one common wall (37).

11. The ducting arrangement of claim 9, wherein the second duct (31) and the third duct (30) share at least one common wall (34).

12. The ducting arrangement of claim 9, wherein the first duct (32) comprises one or more walls (37) separating the front one (14) of the second heat generating components (14, 16) from a front one (40) of the first heat generating components (40, 42), and wherein the first duct (32) comprises at least one outlet (33) for directing air in the first duct (32) towards the rear one (42) of the first heat generating components (40, 42).

13. The ducting arrangement of claim 9, wherein the second duct (31) is positioned between the first duct (32) and the third duct (30).

14. The ducting arrangement of claim 9, further comprising a unitary shell (35) defining the first duct (32), the second duct (31), and the third duct (30).

## Patentansprüche

1. Leitungsanordnung (25) in einer Computervorrichtung, wobei die Leitungsanordnung (25) eine Vielzahl an ersten Wärmeerzeugungskomponenten (40, 42) und eine Vielzahl an zweiten Wärmeerzeugungskomponenten (14, 16) aufweist, wobei die ersten Wärmeerzeugungskomponenten (40, 42) und die zweiten Wärmeerzeugungskomponenten (14, 16) in Bezug auf die eintretende Luft (12) in einer Schattenanordnung angeordnet sind und wobei die ersten Wärmeerzeugungskomponenten (40, 42) in der Computervorrichtung neben den zweiten Wärmeerzeugungskomponenten (14, 16) angeordnet sind,
**gekennzeichnet durch**:
einen oder mehrere erste Kanäle (32), wobei jeder der ersten Kanäle (32) dazu verwendet wird, einen Teil der eintretenden Luft (12) durch eine hintere (42) der ersten Wärmeerzeugungskomponenten (40, 42) und eine vordere (14) der zweiten Wärmeerzeugungskomponenten (14, 16) zu leiten; und
einen oder mehrere zweite Kanäle (31), wobei jeder der zweiten Kanäle (31) dazu verwendet wird, einen anderen Teil der eintretenden Luft (12) durch eine hintere (16) der zweiten Wärmeerzeugungskomponenten (14, 16) zu leiten und die ersten Wärmeerzeugungskomponenten (40, 42) und die vordere (14) der zweiten Wärmeerzeugungskomponenten (14, 16) zu umgehen.

2. Leitungsanordnung nach Anspruch 1, wobei der eine oder die mehreren ersten Kanäle (32) und der eine oder die mehreren zweiten Kanäle (31) zumindest eine gemeinsame Wand (34, 37) teilen.

3. Leitungsanordnung nach Anspruch 1, wobei der eine oder die mehreren ersten Kanäle (32) eine Vielzahl an Kanälen aufweist und wobei ein erster Abschnitt jedes Kanals die vordere (40) der ersten Wärmeerzeugungskomponenten (40, 42) umgeht.

4. Leitungsanordnung nach Anspruch 3, wobei ein zweiter Abschnitt jedes Kanals eine oder mehrere Wände (37) aufweist, die die vordere (14) der zweiten Wärmeerzeugungskomponenten (14, 16) von einer vorderen (40) der ersten Wärmeerzeugungskomponenten (40, 42) trennt, und wobei der zweite Abschnitt jedes Kanals zumindest einen Auslass (33) für das Leiten der Luft in dem zweiten Abschnitt jedes Kanals in Richtung der hinteren (42) der ersten Wärmeerzeugungskomponenten (40, 42) aufweist.

5. Leitungsanordnung nach Anspruch 4, wobei der eine oder die mehreren zweiten Kanäle (31) zwischen dem ersten Abschnitt jedes Kanals und dem zweiten Abschnitt jedes Kanals angeordnet ist/sind.

6. Leitungsanordnung nach Anspruch 1, wobei der eine oder die mehreren ersten Kanäle (32) und der eine oder die mehreren zweiten Kanäle (31) aus einem Material ausgebildet sind, das bei 25°C eine thermische Leitfähigkeit von höchstens 0,55 W/(m K) hat.

7. Leitungsanordnung nach Anspruch 6, wobei das Material, das bei 25°C eine thermische Leitfähigkeit von höchstens 0,55 W/(m K) hat, ein Material ist, das aus der Gruppe ausgewählt ist, die aus Polymeren und Keramiken besteht.

8. Leitungsanordnung nach Anspruch 1, die weiterhin eine einheitliche Hülle (35) aufweist, die den einen oder die mehreren ersten Kanäle (32) und den einen oder die mehreren zweiten Kanäle (31) definiert.

9. Leitungsanordnung (25) nach Anspruch 1, wobei die Leitungsanordnung (25) weiterhin einen dritten Kanal (30) aufweist, wobei der dritte Kanal (30) dazu verwendet wird, noch einen anderen Teil der eintretenden Luft (12) durch die hintere (42) der ersten Wärmeerzeugungskomponenten (40, 42) zu leiten und eine vordere (40) der ersten Wärmeerzeugungskomponenten (40, 42) und die zweiten Wärmeerzeugungskomponenten (14, 16) zu umgehen; und wobei ein Betrag der eintretenden Luft (12), die durch die vordere (14) der zweiten Wärmeerzeugungskomponenten (14, 16) aufgeheizt wird, niedriger ist als ein Betrag der eintretenden Luft (12), die durch die vordere (40) der ersten Wärmeerzeugungskomponenten (40, 42) aufgeheizt wird.

10. Leitungsanordnung nach Anspruch 9, wobei der erste Kanal (32) und der zweite Kanal (31) zumindest eine gemeinsame Wand (37) teilen.

11. Leitungsanordnung nach Anspruch 9, wobei der zweite Kanal (31) und der dritte Kanal (30) zumindest eine gemeinsame Wand (34) teilen.

12. Leitungsanordnung nach Anspruch 9, wobei der erste Kanal (32) eine oder mehrere Wände (37) aufweist, die die vordere (14) der zweiten Wärmeerzeugungskomponenten (14, 16) von einer vorderen (40) der ersten Wärmeerzeugungskomponenten (40, 42) trennt, und wobei der erste Kanal (32) zumindest einen Auslass (33) zum Leiten der Luft im ersten Kanal (32) in Richtung der hinteren (42) der ersten Wärmeerzeugungskomponenten (40, 42) aufweist.

13. Leitungsanordnung nach Anspruch 9, wobei der zweite Kanal (31) zwischen dem ersten Kanal (32) und dem dritten Kanal (30) angeordnet ist.

14. Leitungsanordnung nach Anspruch 9, die weiterhin eine einheitliche Hülle (35) aufweist, die den ersten Kanal (32), den zweiten Kanal (31) und den dritten Kanal (30) definiert.

## Revendications

1. Agencement de tuyauterie (25) dans un dispositif informatique, dans lequel l'agencement de tuyauterie (25) comprend une pluralité de premiers composants générateurs de chaleur (40, 42) et une pluralité de seconds composants générateurs de chaleur (14, 16), dans lequel les premiers composants générateurs de chaleur (40, 42) et les seconds composants générateurs de chaleur (14, 16) sont dans un agencement d'ombre par rapport à l'air entrant (12),
dans lequel les premiers composants générateurs de chaleur (40, 42) sont positionnés dans le dispositif informatique adjacent aux seconds composants générateurs de chaleur (14, 16), **caractérisé en ce que** l'agencement de tuyauterie (25) comprend :
un ou plusieurs premiers tuyaux (32), dans lequel chacun des premiers tuyaux (32) est utilisé pour diriger une partie de l'air entrant (12) à travers un composant arrière (42) des premiers composants générateurs de chaleur (40, 42) et un composant avant (14) des seconds composants générateurs de chaleur (14, 16) ; et
un ou plusieurs deuxièmes tuyaux (31), dans lequel chacun des deuxièmes tuyaux (31) est utilisé pour diriger une autre partie de l'air entrant (12) à travers un composant arrière (16) des seconds composants générateurs de chaleur (14, 16) et contourner les premiers composants générateurs de chaleur (40, 42) et le composant avant (14) des seconds composants générateurs de chaleur (14, 16).

2. Agencement de tuyauterie selon la revendication 1, dans lequel les un ou plusieurs premiers tuyaux (32) et les un ou plusieurs deuxièmes tuyaux (31) partagent au moins une paroi commune (34, 37).

3. Agencement de tuyauterie selon la revendication 1, dans lequel les un ou plusieurs premiers tuyaux (32) comprennent une pluralité de tuyaux, et dans lequel une première partie de chacun des tuyaux contourne un composant avant (40) des premiers composants générateurs de chaleur (40, 42).

4. Agencement de tuyauterie selon la revendication 3, dans lequel une seconde partie de chacun des tuyaux comprend une ou plusieurs parois (37) séparant le composant avant (14) des seconds composants générateurs de chaleur (14, 16) d'un composant avant (40) des premiers composants générateurs de chaleur (40, 42), et dans lequel la seconde partie de chacun des tuyaux comprend au moins une sortie (33) pour diriger l'air dans la seconde partie de chacun des tuyaux vers le composant arrière (42) des premiers composants générateurs de chaleur (40, 42).

5. Agencement de tuyauterie selon la revendication 4, dans lequel les un ou plusieurs deuxièmes tuyaux (31) sont positionnés entre la première partie de chacun des tuyaux et la seconde partie de chacun des tuyaux.

6. Agencement de tuyauterie selon la revendication 1, dans lequel les un ou plusieurs premiers tuyaux (32) et les un ou plusieurs deuxièmes tuyaux (31) sont formés à partir d'un matériau présentant une conductivité thermique d'au plus 0,55 W/(mK) à 25 °C.

7. Agencement de tuyauterie selon la revendication 6, dans lequel le matériau présentant la conductivité thermique d'au plus 0,55 W/(mK) à 25 °C est un matériau sélectionné dans le groupe constitué par des polymères et des céramiques.

8. Agencement de tuyauterie selon la revendication 1, comprenant en outre une coque unitaire (35) définissant les un ou plusieurs premiers tuyaux (32) et les un ou plusieurs deuxièmes tuyaux (31).

9. Agencement de tuyauterie (25) selon la revendication 1, dans lequel l'agencement de tuyauterie (25) comprend en outre :
un troisième tuyau (30), dans lequel le troisième tuyau (30) est utilisé pour diriger encore une autre partie de l'air entrant (12) à travers le composant arrière (42) des premiers composants générateurs de chaleur (40, 42) et contourner un composant avant (40) des premiers composants générateurs de chaleur (40, 42) et les seconds composants générateurs de chaleur (14, 16) ;
dans lequel une quantité de l'air entrant (12) chauffée par le composant avant (14) des seconds composants générateurs de chaleur (14, 16) est inférieure à une quantité de l'air entrant (12) chauffée par le composant avant (40) des premiers composants générateurs de chaleur (40, 42).

10. Agencement de tuyauterie selon la revendication 9, dans lequel le premier tuyau (32) et le deuxième tuyau (31) partagent au moins une paroi commune (37).

11. Agencement de tuyauterie selon la revendication 9, dans lequel le deuxième tuyau (31) et le troisième tuyau (30) partagent au moins une paroi commune (34).

12. Agencement de tuyauterie selon la revendication 9, dans lequel le premier tuyau (32) comprend une ou plusieurs parois (37) séparant le composant avant (14) des seconds composants générateurs de chaleur (14, 16) d'un composant avant (40) des premiers composants générateurs de chaleur (40, 42), et dans lequel le premier tuyau (32) comprend au moins une sortie (33) pour diriger l'air dans le premier tuyau (32) vers le composant arrière (42) des premiers composants générateurs de chaleur (40, 42).

13. Agencement de tuyauterie selon la revendication 9, dans lequel le deuxième tuyau (31) est positionné entre le premier tuyau (32) et le troisième tuyau (30).

14. Agencement de tuyauterie selon la revendication 9, comprenant en outre une coque unitaire (35) définissant le premier tuyau (32), le deuxième tuyau (31) et le troisième tuyau (30).
